(19) **Europäisches Patentamt**

**European Patent Office**

**Office européen des brevets**

(11) **EP 1 341 314 A2**

(12) **EUROPEAN PATENT APPLICATION**

(43) Date of publication:
**03.09.2003 Bulletin 2003/36**

(51) Int Cl.7: **H03M 7/42**

(21) Application number: **03251215.4**

(22) Date of filing: **28.02.2003**

(84) Designated Contracting States:
**AT BE BG CH CY CZ DE DK EE ES FI FR GB GR HU IE IT LI LU MC NL PT SE SI SK TR**
Designated Extension States:
**AL LT LV MK RO**

(30) Priority: **28.02.2002 KR 2002010981**

(71) Applicant: **SAMSUNG ELECTRONICS CO., LTD.**
**Suwon-City, Kyungki-do (KR)**

(72) Inventors:
• **Jang, Heung-yeop, 542-101 Shinnamushil**
  **Suwon-si, Gyeonggi-do (KR)**
• **Jang, Tae-kyu**
  **Gangnam-gu, Seoul (KR)**
• **Jeong, Jong-hoon**
  **Nowon-gu, Seoul (KR)**

(74) Representative: **Geary, Stuart Lloyd et al**
**Venner, Shipley & Co.,**
**20 Little Britain**
**London EC1A 7DH (GB)**

(54) **Improved huffman decoding method and apparatus**

(57) An improved Huffman decoding method and an apparatus thereof are provided. The method comprises (a) receiving the encoded bit stream; (b) obtaining index information from a first bit of a codeword formed with bits of a part of the received encoded bit stream, and accessing an entry of the look-up table corresponding to the index information; and (c) determining the type of the entry based on an internal value of the accessed entry.

FIG. 6

**EP 1 341 314 A2**

**Description**

The present invention relates to a Huffman decoding apparatus comprising memory means storing data defining a Huffman decoding tree.

Due to the unique characteristics of the Huffman code, the prior art Huffman decoding method using a binary tree has been deemed to be a very efficient method from the viewpoint of the maximum search time, average search time, and search time deviation. However, according to the search method based on a conventional binary tree, in order to generate a data structure for searching, a complicated process for constructing a representation of a binary tree must be performed. Also, comparison and branch statements for transition between nodes in a binary tree search slow the processing flow of the operations of a processor, thereby decreasing the processing speed of a Huffman decoder.

The structure and operation of the prior art Huffman decoding apparatus and the prior art Huffman decoding method performed in the apparatus will now be explained referring to Figures 1 to 5.

Figure 1 is a schematic block diagram of the prior art Huffman decoding apparatus. The apparatus comprises an input buffer 110, a search engine 120, a Huffman look-up table 130, and an output buffer 140.

Figure 2 is a flowchart for explaining the prior art Huffman decoding method of a Huffman decoder based on a conventional conditional branch statement, the method performed in the apparatus shown in Figure 1.

Figure 3 is a diagram showing a binary Huffman tree structure according to the prior art method. Nodes 310, 322, 330, 332, 342, 344, and 356 are internal nodes that branch to child nodes. Nodes 320, 340, 346, 350, 352, 354, 360, and 362 are terminal nodes that have return values to be output.

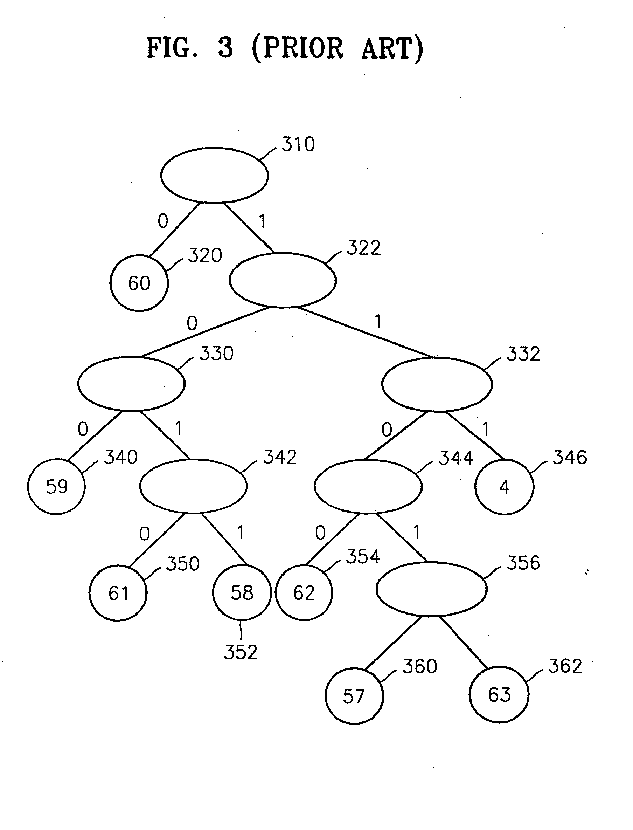

The following Table 1 is the codebook of the binary Huffman tree shown in Figure 3.

Table 1

| Codeword | Value |
| --- | --- |
| 0 | 60 |
| 100 | 59 |
| 1010 | 61 |
| 1011 | 58 |
| 1100 | 62 |
| 11010 | 57 |
| 11011 | 63 |
| 111 | 4 |

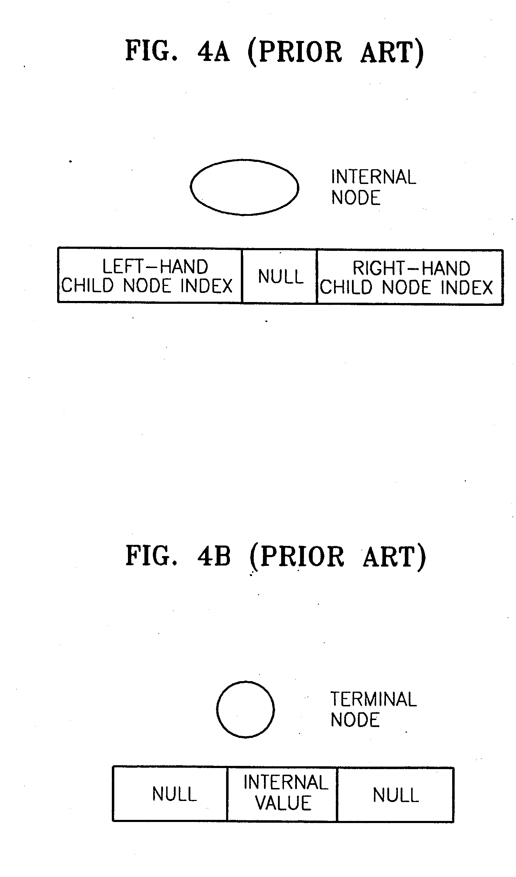

Figures 4a and 4b are diagrams showing the memory structure of a Huffman table according to the prior art binary tree Huffman decoding method. Referring to Figures 4a and 4b, the prior art Huffman table uses 3 memory spaces to represent each node. Referring to Figure 4a, for an internal node, a null value is stored in the middle memory space among the 3 allocated memory spaces, the address of a left-hand node of the children nodes is stored in the left-hand memory space, and the address of a right-hand node of the children nodes is stored in the right-hand memory space. Also, referring to Figure 4b, for a terminal node, an internal value of the node, that is, the return value to be output, is stored in the middle memory space of the 3 allocated memory spaces, and null values are stored in the left-hand and right-hand memory spaces.

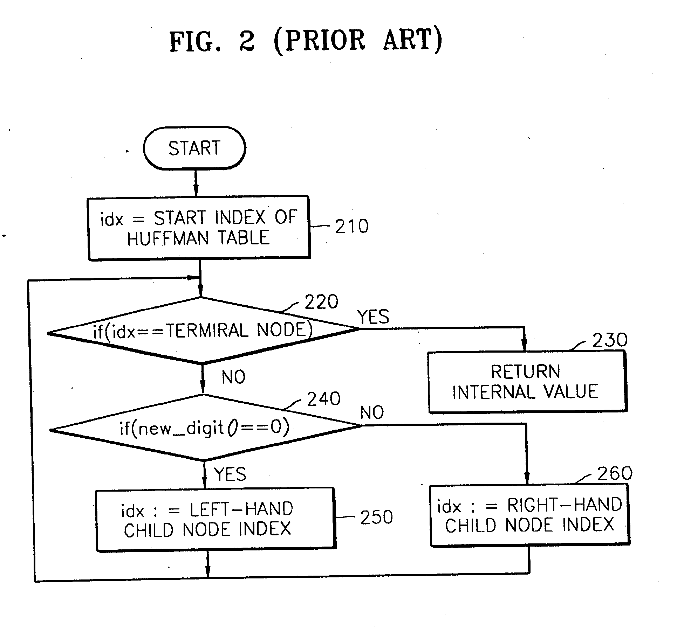

Referring to Figures 3 through 5, and based on the flowchart shown in Figure 2, the decoding method of a Huffman decoder using the Huffman table of the prior art binary tree structure will now be explained.

Step 210 is the first step of the decoding process. In step 210, based on the codeword of an encoded bit stream, which is input to the Huffman decoder, an entry corresponding to the root node of the Huffman tree shown in Figure 3, that is, the internal node 310, is accessed.

Step 220 is a comparison and branch statement, and in step 220 it is determined whether the node corresponding to the entry accessed in step 210 is an internal node or a terminal node.

In step 230, if it is determined in step 220 that the node corresponding to the accessed entry is a terminal node, the value stored in the middle memory space among the 3 memory spaces allocated to the terminal node is output as a decoded codeword value.

In step 240, if it is determined in step 220 that the node corresponding to the accessed entry is an internal node, it is determined whether the value of 1 bit input from the bit stream is '0' or '1'. If the value is '0', step 250 is performed and if the value is '1', step 260 is performed.

In step 250, an entry corresponding to the address stored in the left-hand memory space among the 3 memory spaces allocated to the current node is accessed and then step 220 is performed.

In step 260, an entry corresponding to the address stored in the right-hand memory space among the 3 memory spaces allocated to the current node is accessed and then step 220 is performed.

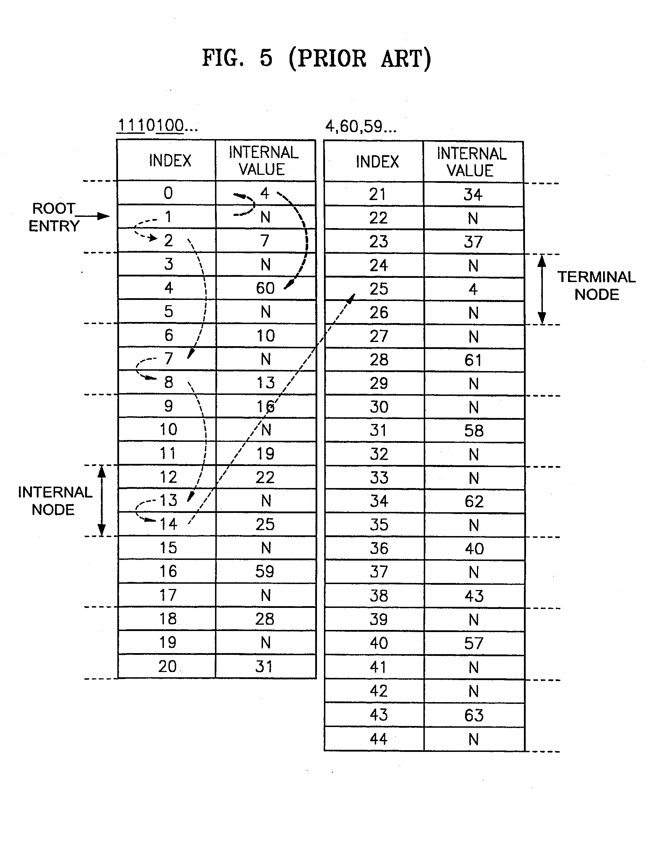

Referring to Figures 2 and 5, a process for decoding an input bit stream '1110100...', which is encoded according to the prior art Huffman decoding method described above, will now be explained.

In step 210, the first step of decoding, the entry corresponding to the root node of the Huffman binary tree, the entry which corresponds to address '1' of the Huffman table shown in Figure 5, is accessed.

In step 220, it is determined whether the node to which the accessed entry belongs is an internal node or a terminal node. Referring to Figure 5, the value stored in the middle memory space of the 3 memory spaces of the node corresponding to address '1' is 'NULL', '4' is stored in the left-hand memory space and '7' is stored in the right-hand memory space. Accordingly, in step 220 it is determined that the node corresponding to the address '1' is an internal node, as shown in Figure 4a, and step 240 is performed.

In step 240, the first bit '1' of the first encoded codeword of the input bit stream '<u>1</u>110100' is input. Because the input bit (new digit()) is '1', step 260 is performed.

In step 260, an entry corresponding to the address '7' stored in the right-hand address '2' of the current address '1', that is, in the right-hand memory space of the current node, is accessed, and step 220 is performed.

In step 220, it is determined whether the node corresponding to address '7' of the Huffman table is an internal node or a terminal node. Referring to Figure 5, the value stored in the middle memory space of the 3 memory spaces of the node corresponding to address '7' is 'NULL', '10' is stored in the left-hand memory space and '13' is stored in the right-hand memory space. Accordingly, in step 220 it is determined that the node corresponding to address '7' is an internal node, as shown in Figure 4a, and step 240 is performed.

In step 240, the second bit '1' of the first encoded codeword of the input bit stream '1<u>1</u>10100' is input. Because the input bit (new digit) is '1', step 260 is performed.

In step 260, an entry corresponding to the address '13' stored in the right-hand address '8' of the current address '7', that is, in the right-hand memory space of the current node, is accessed, and step 220 is performed.

In step 220, it is determined whether the node corresponding to address '13' of the Huffman table is an internal node or a terminal node. Referring to Figure 5, the value stored in the middle memory space of the 3 memory spaces of the node corresponding to address '13' is 'NULL', '22' is stored in the left-hand memory space and '25' is stored in the right-hand memory space. Accordingly, in step 220 it is determined that the node corresponding to address '13' is an internal node, as shown in Figure 4a, and step 240 is performed.

In step 240, the third bit '1' of the first encoded codeword of the input bit stream '11<u>1</u>0100' is input. Because the input bit (new digit()) is '1', the step 260 is performed.

In step 260, an entry corresponding to the address '25' stored in the right-hand address '14' of the current address '13', that is, in the right-hand memory space of the current node, is accessed, and step 220 is performed.

In step 220, it is determined whether the node corresponding to address '25' of the Huffman table is an internal node or a terminal node. Referring to Figure 5, the value stored in the middle memory space of the 3 memory spaces of the node corresponding to address '25' is '4', 'NULL' is stored in the left-hand memory space and 'NULL' is stored in the right-hand memory space. Accordingly, in step 220 it is determined that the node corresponding to address '25' is a terminal node shown in Figure 4b, and step 230 is performed.

In step 230, the value '4' stored in the middle memory space among the 3 memory spaces allocated to the node corresponding to address '25' is output as a decoded codeword value.

Accordingly, the decoded codeword '4' corresponding to the first codeword '111' of the input bit stream '1110100' is obtained, and decoding of the second codeword of the bit stream '1110100' is performed.

In the same manner as in the process for obtaining the decoded codeword value '4', in step 210, the first step of the decoding, the entry corresponding to address '1' of the Huffman table, that is, the root node of the Huffman binary tree, is accessed and then step 220 is performed.

In step 220, it is determined whether the accessed node corresponding to address '1' of the Huffman table is an internal node or a terminal node. The value stored in the middle memory space of the 3 memory spaces of the node corresponding to address '1' is 'NULL', '4' is stored in the left-hand memory space and '7' is stored in the right-hand memory space. Accordingly, in step 220 it is determined that the node corresponding to address '1' is an internal node, as shown in Figure 4a, and step 240 is performed.

In step 240, the first bit '0' of the second codeword of the input bit stream '111<u>0</u>100' is input. Because the input bit (new digit()) is '0', step 250 is performed.

In step 250, an entry corresponding to the address '4' stored in the left-hand address '0' of the current address '1', that is, the left-hand memory space of the current node, is accessed and step 220 is performed.

In step 220, it is determined whether the node corresponding to the address '4' of the Huffman table is an internal node or a terminal node. Referring to Figure 5, the value stored in the middle memory space of the 3 memory spaces of the node corresponding to address '4' is '60', 'NULL' is stored in the left-hand memory space and 'NULL' is stored in the right-hand memory space. Accordingly, in step 220 it is determined that the node corresponding to the address '4' is a terminal node, as shown in Figure 4b, and step 230 is performed.

In step 230, the value '60' stored in the middle memory space among the 3 memory spaces allocated to the node corresponding to the address '4' is output as a decoded codeword value corresponding to the second codeword '0' of the bit stream "1110100'.

In this manner, the decoded codeword value '59' corresponding to the third codeword '100' of the encoded bit stream '1110100' input to the Huffman decoder is output. By doing so, decoded codeword values '4, 60, 59, ...' corresponding to the bit stream '1110100...' are obtained.

Thus, in the prior art Huffman decoding method based on a binary tree, a complicated process for generating the data structure needed for searching must be performed. In particular, comparison and branch statements for transition between nodes in a binary tree search reduce the processing flow of the operations of a processor such that the operational speed decreases. Also, since each node uses 3 memory spaces in the look-up table according to the prior art Huffman decoding method, memory spaces are excessively consumed.

A Huffman decoding apparatus, according to the present invention, is characterised in that the root node of the tree is not represented and each other node of the tree is represented in the memory means by a single item of a simple data type. Preferably all nodes are represented using the same simple data type. More preferably, terminal nodes and internal nodes are represented by items having different parity. Still more preferably, terminal nodes are represented by items having positive values and internal nodes are represented by items having negative values. Even more preferably, the apparatus includes processing means, wherein said processing means is responsive to the first bit of a Huffman code to select a first represented node to be visited. Yet more preferably, the processing means is configured to calculate the index of a next entry to be accessed using the equation; $index_{next\ entry} = index_{current\ entry} - data\ item_{current\ entry} + bit\ value_{next\ bit}$, wherein $index_{current\ entry}$ denotes the index number of a current entry, data $item_{current\ entry}$ denotes the return value of the current entry, and bit $value_{next}$ bit denotes a next bit value in said Huffman code.

The present invention provides an improved Huffman decoding method in which 'comparison and branch' commands that decrease processing efficiency in the prior Huffman decoding process are omitted so that the operational speed of a Huffman decoder is increased and the required memory resources are decreased.

The present invention also provides an improved Huffman decoding system which performs the improved Huffman decoding method in which 'comparison and branch' commands that decrease processing efficiency in the prior Huffman decoding process are omitted, so that the operational speed of a Huffman decoder is increased and the required memory resources are decreased.

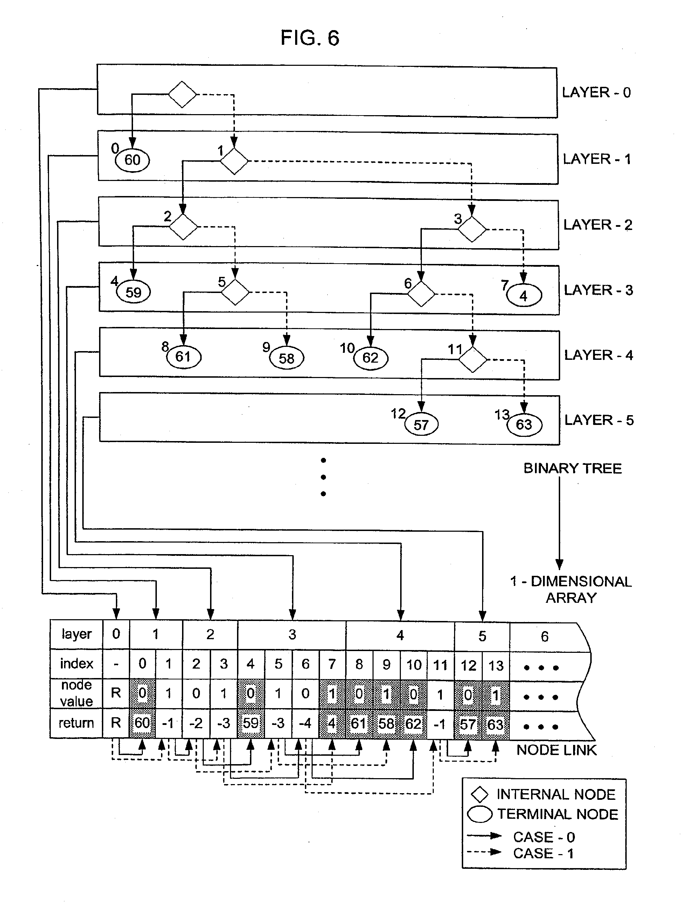

Embodiments of the present invention will now be described, by way of example, with reference to Figures 6 to 9, in which:

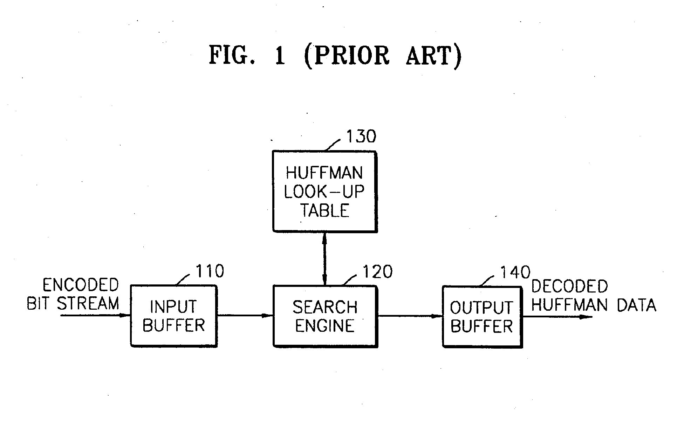

Figure 1 is a schematic block diagram of a prior art Huffman decoding apparatus;
Figure 2 is a flowchart for explaining the prior art Huffman decoding method performed in the apparatus shown in Figure 1;
Figure 3 is a diagram showing a binary tree structure, which is used in the Huffman decoding method;
Figures 4a and 4b are diagrams showing memory spaces of a Huffman table, corresponding to respective nodes used in the prior art Huffman decoding method;
Figure 5 is a Huffman table used in the prior art Huffman decoding method;
Figure 6 is a schematic diagram showing a process for generating a one-dimensional look-up table according to an embodiment of the present invention;

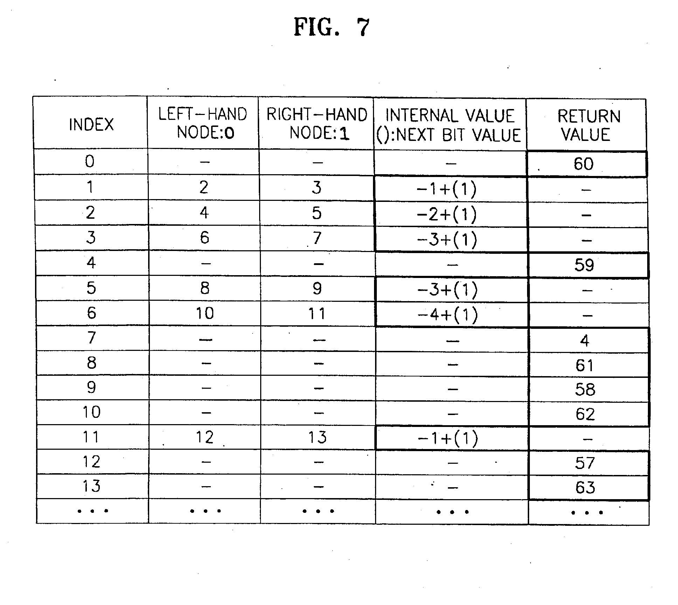

Figure 7 is a table showing a process for generating a one-dimensional look-up table according to an embodiment of the present invention;

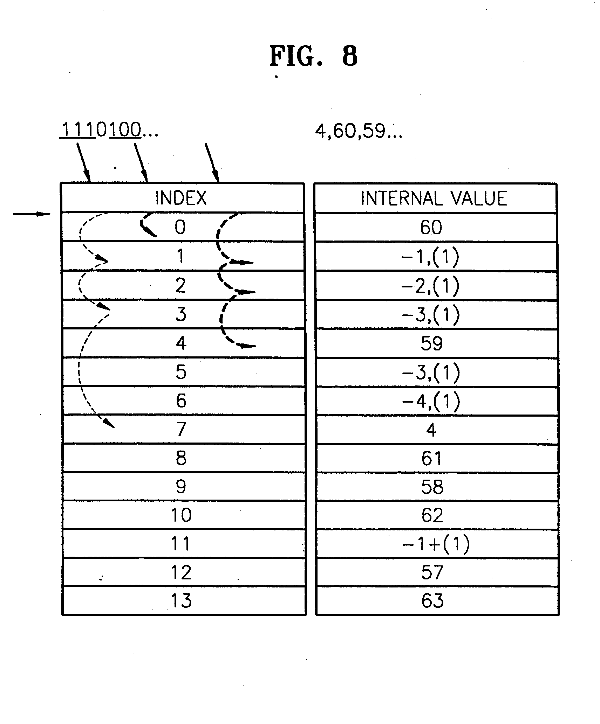

Figure 8 is a one-dimensional look-up table used in a decoding method according to an embodiment of the present invention; and

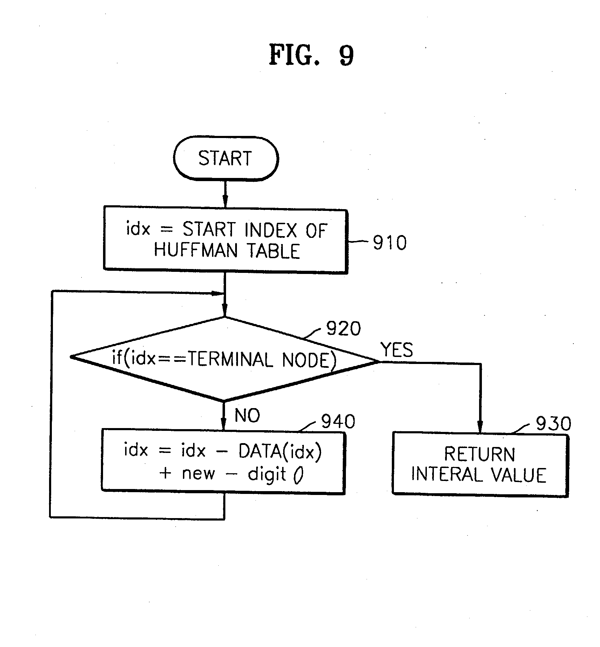

Figure 9 is a flowchart for explaining an improved Huffman decoding method based on numerical operations, according to an embodiment of the present invention.

Referring to Figure 6, in the table converting process, the nodes of a binary tree are grouped in each identical search stage, and are arranged in a one-dimensional array such that the size of the codewords, as shown in Table 1, increases from left to right. When the look-up table shown in Figure 6 is generated, each internal node stores a relative distance between the location of the current node and a node which will be accessed next, as an internal value, and each terminal node stores a return value that is to be output, as an internal value.

The one-dimensional array is generated in a sorting process and has the structure of a serial static look-up table as shown in Figure 6.

Referring to Figure 6, the generation process of the one-dimensional look-up table will now be explained in more detail. In the binary tree of Figure 6, index numbers are sequentially given to respective nodes from the upper layer to the lower layer, that is, in order of layer-0, layer-1, layer-2, layer-3, layer-4, and layer-5. Also, in an identical layer, index numbers are sequentially given to respective nodes. In a preferred embodiment of the present invention, continuous index numbers are given to sibling nodes as shown in Figure 6. Though index numbers are given from the left-hand side to the right-hand side in an identical layer in the present embodiment, index numbers may be given from the right-hand side to the left-hand side in an identical layer. Additionally, in the present embodiment, no index number is given to the root node of the binary tree in layer-0.

In Figure 6, return values of '60', '59', '4', '61', '58', '62', '57', and '63' are allocated respectively, to the terminal nodes to which index numbers 0, 4, 7, 8, 9, 10, 12 and 13 are given, from the left-hand side to the right-hand side in increasing order of the size of codewords shown in table 1.

Furthermore, relative distance values between the current node and a node which will be accessed next are stored, respectively, in the internal nodes to which index numbers 1, 2, 3, 5, 6, 11, ... are given,. In the present embodiment, in the internal nodes to which index numbers 1, 2, 3, 5, 6, 11 are given, the difference values of the index numbers of the current node and the index numbers of the left-hand child nodes, that is, '-1', '-2', '-3', '-3', '-4', and '-1', are stored, respectively.

Figure 7 shows a one-dimensional look-up table constructed according to the table reconstruction method shown in Figure 6. The reconstructed one-dimensional look-up table contains the index numbers given to respective nodes of the binary tree and the internal values of the nodes stored in relation to the index numbers. The internal value of each internal node stored in the look-up table is the relative distance value between the current node and a node which will be accessed next, that is, the difference between the index number of the current node and the index number of the left-hand node of the children nodes in the present embodiment, and therefore is always a negative value. The internal value of each terminal node is a result value which will be output and therefore is a positive value.

Although in the present embodiment, each internal node has a difference value between the index number of the current node and the index number of the left-hand child node, other relative distance values such as the difference value from the index number of the right-hand node may be stored selectively in other embodiments.

The columns named 'Left-hand node: 0' and 'Right-hand node: 1' in the one-dimensional look-up table shown in Figure 7 are not included in the final look-up table shown in Figure 8, and show an intermediate process for generating a table. These columns indicate search address values, which will be accessed next in a search process. Together with 1 bit of data read from an encoded bit stream, each item in these columns indicates the index number of a node in a search stage for moving to a next node.

In the prior art binary tree Huffman look-up table, the look-up table must have 3 elements for each node, including the data value of the node and address values for moving to a next node when branching to the left-hand node or the right-hand node is performed. Accordingly, 3 memory spaces are needed for each node of the binary tree.

In the final look-up table according to an embodiment of the present invention shown in Figure 8, each internal node has only a relative distance value between the current node and a node which will be accessed next, and each terminal node has only a result value which will be output. Also, each of these two values as indicated by thick lines in Figure 7 always occur exclusively, and therefore, each of them can be arranged in a one-dimensional space as shown in Figure 8. Accordingly, compared to the prior art look-up table the required memory space is reduced to a third.

Referring to Figure 9, in step 910, the first step of decoding using the one-dimensional look-up table, an entry of the look-up table of Figure 8 is accessed by using the first bit value of a predetermined codeword of an encoded bit stream which is input to the Huffman decoder, as index information.

In step 920, it is determined whether the current node corresponding to the entry accessed in step 910 is an internal node or a terminal node. In the present embodiment, the type of a node is determined according to whether the internal value of the corresponding entry is a positive value or a negative value.

In step 920, if the internal value stored in the corresponding entry is a positive value, it is determined that the current node is a terminal node, and step 930 is performed. If the internal value is a negative value, it is determined that the current node is an internal node, and step 940 is performed.

When it is determined in step 920 that the current node is a terminal node, the internal value of the current node is output as a return value, in step 930.

When it is determined in step 920 that the current node is an internal node, a new index value is calculated according to the following equation 1 in step 940, and an entry in the look-up table corresponding to the calculated index value is accessed:

$$\text{index} = \text{index} - \text{data (index)} + \text{new\_digit()} \tag{1}$$

In equation 1, "index" on the right side denotes the index number of the current node, data(index) denotes a relative distance value between the current node stored as an internal value in the current entry and a node which will be accessed next, and new_digit() denotes the next bit value in the input bit stream.

In the present embodiment, the relative distance value is the difference value between the index number of the current node and the index number of the left-hand child node of the current node.

Referring to the one-dimensional look-up table according to the present invention shown in Figure 8 and the flowchart shown in Figure 9, a process for decoding '1110100' in an encoded bit stream which is input to the Huffman decoder will now be explained.

In step 910, the first step of decoding, an entry of the look-up table of Figure 8 is accessed by using the first bit '1' of the first codeword of an encoded bit stream '1110100' which is input to the Huffman decoder, as index information. Here, it is assumed that a codeword corresponding to a predetermined return value begins from the first bit of the bit stream '1110100'.

In step 920, it is determined whether the current node is an internal node or a terminal node, based on the sign of the internal value of the node corresponding to the current entry accessed in step 910, that is, the entry having the index value 1 of the look-up table of Figure 8. In the present embodiment, since the internal value of the entry having the index value 1 is a negative value '-1' in step 920, it is determined that the current node is an internal node and step 940 is performed.

In step 940, a new index value is calculated from equation 1 and a new entry is accessed according to the calculated index value, and then step 920 is performed. In the present embodiment, data(index) is the result value of index number 1 - index number 2 (i.e. data(index) = -1 in this case), and new_digit( ) is the next bit value '1' in the bit stream '1110100' to be decoded. Accordingly, the new index value is index = 1 - (-1) + 1 = 3. Therefore, in step 940, an entry corresponding to index 3 is accessed and then step 920 is performed.

In step 920, it is determined whether the node of the current entry accessed in step 940, that is, the entry corresponding to index 3 of the look-up table of Figure 8, is an internal node or a terminal node. In step 920, since the internal value of the entry is a negative value '-3', it is determined that the current node is an internal node, and step 940 is performed again.

In step 940, according to equation 1, a new index value is calculated. In this case data(index) is the difference between index 3 and index 6, i.e. 3 - 6 = -3. Since new_digit( ) is the second bit value '1' of the first codeword in the bit stream '1110100' to be decoded, the new index value is index = 3 - (-3) + 1 = 7. Therefore, an entry corresponding to index 7 is accessed and then step 920 is performed.

In step 920, it is determined whether the node of the current entry accessed in step 940, that is, the entry corresponding to index 7 of the look-up table of Figure 8, is an internal node or a terminal node. In step 920, since the internal value of the entry is a positive value, it is determined that the current node is a terminal node, and step 930 is performed.

In step 930, the internal value '4' of the entry corresponding to index 7 is output as a result value, that is, a decoded codeword. By doing so, the decoding steps for the first bit set in the encoded bit steam '1110100', that is, the codeword '111', are finished, and then decoding of a second codeword begins.

In step 910, an entry of the look-up table of Figure 8 is accessed by using the first bit '0' of the second codeword of the bit stream '1110100'.

In step 920, since the internal value of the entry corresponding to index 0 accessed in step 910 is a positive value, it is determined that the current node is a terminal node and step 930 is performed.

In step 930, the internal value '60' of the entry corresponding to index 0 is output as a decoded codeword. By doing so, the decoding steps for the second codeword '0' of the encoded bit steam '1110100', are finished, and then decoding of a third codeword begins.

In the step 910, an entry of the look-up table of Figure 8 is accessed by using the first bit '1' of the third codeword of the bit stream '1110100'.

In step 920, since the internal value of the current entry accessed in step 910, that is, the entry corresponding to index 1, is a negative value '-1', it is determined that the current node is an internal node and step 940 is performed.

In step 940, according to equation 1, a new index value is calculated. Since new_digit( ) is the second bit value '0' in the bit stream '1110100' to be decoded, the new index value is index = 1 - (-1) + 0 = 2. Therefore, an entry corresponding to index 2 is accessed and then step 920 is performed.

In step 920, it is determined whether the node of the current entry accessed in step 940, that is, the entry corresponding to index 2 of the look-up table of Figure 8, is an internal node or a terminal node. In the present embodiment, since the internal value of the current entry is a negative value '-2', it is determined that the current node is an internal node, and step 940 is performed.

In step 940, according to equation 1, a new index value is calculated. Since new_digit() is the third bit value '0' of the third codeword in the bit stream '1110100' to be decoded, the new index value is index = 2 - (-2) + 0 = 4. Therefore, an entry corresponding to index 4 is accessed and then step 920 is performed.

In step 920, it is determined whether the node of the current entry accessed in step 940, that is, the entry corresponding to index 4 of the look-up table of Figure 8, is an internal node or a terminal node. In step 920, since the internal value of the current entry is a positive value '59', it is determined that the current node is a terminal node and step 930 is performed.

In step 930, the internal value '59' of the current entry is output as a decoded codeword of the third codeword '100' of the encoded bit stream '1110100'.

Thus, decoding for 3 codewords in the encoded bit stream '1110100' is performed and decoded codewords '4, 60, 59' are output as result values.

Therefore, when the process for performing the Huffman decoding method based on the prior art binary tree is compared with the process for performing the improved Huffman decoding method according to the present embodiment, it is shown that the Huffman decoding method applies 1 data bit which is input from the encoded bit stream, to directly access an entry of the look-up table, that is, to calculate address values so that conditional statements, which are needed for transition between nodes in the prior art Huffman decoding method, are removed. Accordingly, the Huffman decoding method according to the present invention achieves improved processing efficiency.

Table 2 shows the performance results of the improved Huffman decoding method according to the present invention and the Huffman decoding method by the prior art sequential search method.

Table 2

| Huffman codebook | Search stage/ table size | Total search frequency | Average search frequency | | Improvement of search speed (%) |
|---|---|---|---|---|---|
| | | | Proposed search method | Sequential search method | |
| Scale factor | 19/121 | 14022 | 3.91 | 5.09 | 30.01 |
| 1 | 16/81 | 5624 | 4.52 | 12.50 | 177.98 |
| 2 | 16/81 | 7857 | 5.39 | 18.61 | 245.11 |
| 3 | 16/81 | 16710 | 3.77 | 6.46 | 71.11 |
| 4 | 16/81 | 8680 | 4.77 | 11.42 | 139.32 |
| 5 | 16/81 | 28794 | 3.08 | 4.51 | 46.35 |
| 6 | 16/81 | 1086 | 5.17 | 14.04 | 172.58 |
| 7 | 16/64 | 2958 | 2.64 | 3.29 | 24.80 |
| 8 | 16/64 | 582 | 4.81 | 11.13 | 131.28 |
| 9 | 16/169 | 234 | 2.94 | 5.09 | 73.26 |
| 10 | 16/169 | 2594 | 6.51 | 33.60 | 415.63 |
| 11 | 16/289 | 7640 | 7.41 | 65.02 | 776.43 |

As shown in the performance results of Table 2, when arbitrary MPEG-2 advanced audio coding (AAC) test files were tested, performance improvement was achieved by a minimum of 25% to a maximum of 776% according to the types of Huffman codebooks. Also, from the viewpoint of average search frequency, the Huffman decoding method according to the present embodiment showed about 75% performance improvement compared with the Huffman decoder using an ordinary sequential search method.

Table 3 shows the test results of the methods by using 6 different MPEG-2 AAC files under the same measuring environments.

Table 3

| Test file | Total search frequency | | Improvement of search speed (%) |
|---|---|---|---|
| | Proposed search method | Sequential search method | |
| test01.aac | 407,591 | 1,168,714 | 187 |
| test02.aac | 404,608 | 1,238,404 | 206 |
| test03.aac | 360,727 | 1,236,965 | 243 |

Table 3   (continued)

| Test file | Total search frequency | | Improvement of search speed (%) |
|---|---|---|---|
| | Proposed search method | Sequential search method | |
| test04.aac | 371,423 | 941,376 | 153 |
| test05.aac | 174,997 | 511,710 | 192 |
| test06.aac | 239,362 | 740,700 | 209 |
| Average | 326,451 | 972,978 | 198 |

As shown in Table 3, the improved Huffman decoding method according to the present embodiment improves the search speed by a minimum of 153% and a maximum of 243% according to the types of file, compared with the Huffman decoding method of the prior art sequential search method.

The present invention may be embodied in a code, which can be read by a computer, on a computer readable recording medium. The computer readable recording medium includes all kinds of recording apparatuses on which computer readable data are stored.

The computer readable recording media includes storage media such as magnetic storage media (e.g., ROM's, floppy disks, hard disks, etc.) and optically readable media (e.g., CD-ROMs, DVDs, etc.). The present invention may be embodied in a signal, which may be suitable for transmission over the Internet. Also, the computer readable recording media can be transmitted to computer systems connected through a network, and it can store and execute a computer readable code in a distributed mode.

According the improved Huffman decoding method and apparatus of the present invention as described above, 'comparison and branch' operations needed in the prior art binary tree search are removed, thereby increasing the search speed. Also, a look-up table can be implemented with a memory space, which is only a third of the memory space of the prior art table that is used for the 'comparison and branch' statements.

**Claims**

1. A Huffman decoding apparatus comprising memory means storing data defining a Huffman decoding tree **characterised in that** the root node of the tree is not represented and each other node of the tree is represented in the memory means by a single item of a simple data type.

2. An apparatus according to claim 1, wherein all nodes are represented using the same simple data type.

3. An apparatus according to claim 1 or 2, wherein terminal nodes and internal nodes are represented by items having different parity.

4. An apparatus according to claim 1, 2 or 3, wherein terminal nodes are represented by items having positive values and internal nodes are represented by items having negative values.

5. An apparatus according to claim 1, 2, 3 or 4, including processing means, wherein said processing means is responsive to the first bit of a Huffman code to select a first represented node to be visited.

6. An apparatus according to claim 5, wherein the processing means is configured to calculate the index of a next entry to be visited using the equation:

$$\text{index}_{\text{next entry}} = \text{index}_{\text{current entry}} - \text{data item}_{\text{current entry}} + \text{bit value}_{\text{next bit}}$$

   wherein $\text{index}_{\text{current entry}}$ denotes the index number of a current entry, $\text{data item}_{\text{current entry}}$ denotes the return value of the current entry, and $\text{bit value}_{\text{next bit}}$ denotes a next bit value in said Huffman code.

7. A decoding method for decoding an encoded bit stream using a look-up table, the method comprising:

(a) receiving the encoded bit stream;

(b) obtaining index information from a first bit of a codeword formed with bits of a part of the received encoded bit stream, and accessing an entry of the look-up table corresponding to the index information; and

(c) determining the type of the entry based on an internal value of the accessed entry.

**8.** The decoding method of claim 7, wherein in the step (c) it is determined whether the entry corresponds to an internal node or a terminal node, according to the sign of the internal value of the accessed entry.

**9.** The decoding method of any one of claims 7 and 8, further comprising:

(d) if it is determined in the step (c) that the accessed entry corresponds to an internal node, calculating an index value of an entry which will be accessed next, based on the index value of the current entry, the internal value of the accessed entry, and the second bit value of the codeword.

**10.** The decoding method of claim 9, wherein the index value which will be accessed next is calculated according to the following equation:

$$index = index - data(index) + new\_digit(\ )$$

where index denotes the index number of a current entry, data(index) denotes a return value of the current entry, and new_digit( ) denotes a next bit value in the codeword, and a step for accessing an entry of the look-up table corresponding to the calculated index value is further included.

**11.** The decoding method of any one of claims 9 and 10, wherein the internal value of the current entry is a relatively distance between the current node and a node which will be accessed next.

**12.** The decoding method of any one of claims 9 and 10, wherein the entry to be accessed next is an entry corresponding to a left-hand node of children nodes of a node corresponding to the current node, and the relative distance is a difference value between the index value of the current entry and the index value of the entry corresponding to the left-hand node.

**13.** The decoding method of claim 9, further comprising.
if it is determined in the step (c) that the accessed entry corresponds to an internal node, accessing an entry of the look-up table, based on a value obtained by adding the index value of the accessed entry, the absolute value of the internal value, and the next bit value of the codeword.

**14.** The decoding method of any one of claims 7 and 8, further comprising:

(e) if it is determined in the step (c) that the accessed entry corresponds to a terminal node, outputting the internal value of the look-up table as a decoded codeword of a codeword formed with bits of a part of the encoded bit stream.

**15.** The decoding method of claim 9, wherein the step (c) further comprises:

(c1) determining whether the accessed entry corresponds to an internal node or a terminal node, using the calculated index and based on an internal value of an entry of the look-up table corresponding to the index.

**16.** The decoding method of claim 15, wherein the step (c) further comprises:

(c2) if it is determined that the node of the entry is a terminal node, outputting the internal value of the look-up table as a decoded codeword of a predetermined encoded codeword of the encoded bit stream.

**17.** The decoding method of claim 7, wherein the encoded bit stream is encoded by one of the motion pictures experts group (MPEG) standard, the joint photographic coding experts group (JPEG) standard, and the H.26x standard.

**18.** The decoding method of claim 7, wherein the look-up table is generated from a binary tree.

**19.** A decoding apparatus for decoding an encoded bit stream according to a binary tree search, the apparatus comprising:

a processor which decodes the encoded bit stream; and
a memory which is connected to the processor and stores a look-up table related to the decoding

wherein the look-up table has entries which correspond to respective nodes of the binary tree and have internal values, and the type of a node of the binary tree corresponding to each entry is determined by the internal value stored in relation with the entry.

**20.** The decoding apparatus of claim 19, wherein the internal value stored in relation with the entry has a different sign according to the type of a node corresponding to the entry.

**21.** The decoding apparatus of any one of claims 19 and 20, wherein if the node corresponding to the entry is an internal node, the internal value of the entry is a relative distance value between the internal node which is the current node, and a node to be accessed next.

**22.** The decoding apparatus of claim 21, wherein the entry to be accessed next for obtaining the internal value of the current entry is an entry corresponding to a left-hand node of children nodes of a node corresponding to the current entry, and the relative distance is a difference value between the index value of the current entry and the index value of an entry corresponding to the left-hand node.

**23.** The decoding apparatus of any one of claims 19 and 20, wherein if the entry corresponds to a terminal node, the internal value of the entry is a decoded codeword of a predetermined codeword of the bit stream.

**24.** The decoding apparatus of claim 19, wherein the encoded bit stream is encoded by one of the MPEG standard, the JPEG standard, and the H.26x standard.

# FIG. 1 (PRIOR ART)

# FIG. 2 (PRIOR ART)

START

idx = START INDEX OF HUFFMAN TABLE — 210

if(idx==TERMIRAL NODE) — 220    YES →    RETURN INTERNAL VALUE — 230

NO

if(new_digit()==0) — 240    NO →    idx : = RIGHT-HAND CHILD NODE INDEX — 260

YES

idx : = LEFT-HAND CHILD NODE INDEX — 250

# FIG. 3 (PRIOR ART)

# FIG. 4A (PRIOR ART)

INTERNAL
NODE

| LEFT—HAND CHILD NODE INDEX | NULL | RIGHT—HAND CHILD NODE INDEX |
|---|---|---|

# FIG. 4B (PRIOR ART)

TERMINAL
NODE

| NULL | INTERNAL VALUE | NULL |
|---|---|---|

## FIG. 5 (PRIOR ART)

1110100...

| INDEX | INTERNAL VALUE |
|-------|----------------|
| 0 | 4 |
| 1 | N |
| 2 | 7 |
| 3 | N |
| 4 | 60 |
| 5 | N |
| 6 | 10 |
| 7 | N |
| 8 | 13 |
| 9 | 16 |
| 10 | N |
| 11 | 19 |
| 12 | 22 |
| 13 | N |
| 14 | 25 |
| 15 | N |
| 16 | 59 |
| 17 | N |
| 18 | 28 |
| 19 | N |
| 20 | 31 |

4,60,59...

| INDEX | INTERNAL VALUE |
|-------|----------------|
| 21 | 34 |
| 22 | N |
| 23 | 37 |
| 24 | N |
| 25 | 4 |
| 26 | N |
| 27 | N |
| 28 | 61 |
| 29 | N |
| 30 | N |
| 31 | 58 |
| 32 | N |
| 33 | N |
| 34 | 62 |
| 35 | N |
| 36 | 40 |
| 37 | N |
| 38 | 43 |
| 39 | N |
| 40 | 57 |
| 41 | N |
| 42 | N |
| 43 | 63 |
| 44 | N |

ROOT ENTRY

INTERNAL NODE

TERMINAL NODE

15

FIG. 6

LAYER - 0

LAYER - 1

0 60
1

LAYER - 2

2
3

LAYER - 3

4 59
5
6
7 4

LAYER - 4

8 61
9 58
10 62
11

LAYER - 5

12 57
13 63

BINARY TREE

1 - DIMENSIONAL ARRAY

| layer | 0 | 1 | | 2 | | 3 | | | 4 | | | | 5 | | 6 |
|---|---|---|---|---|---|---|---|---|---|---|---|---|---|---|---|
| index | - | 0 | 1 | 2 | 3 | 4 | 5 | 6 | 7 | 8 | 9 | 10 | 11 | 12 | 13 | • • • |
| node value | R | 0 | 1 | 0 | 1 | 0 | 1 | 0 | 1 | 0 | 1 | 0 | 1 | 0 | 1 | • • • |
| return | R | 60 | -1 | -2 | -3 | 59 | -3 | -4 | 4 | 61 | 58 | 62 | -1 | 57 | 63 | • • • |

NODE LINK

◇ INTERNAL NODE
○ TERMINAL NODE
→ CASE - 0
⤍ CASE - 1

16

# FIG. 7

| INDEX | LEFT—HAND NODE:0 | RIGHT—HAND NODE:1 | INTERNAL VALUE ():NEXT BIT VALUE | RETURN VALUE |
|---|---|---|---|---|
| 0 | — | — | — | 60 |
| 1 | 2 | 3 | −1+(1) | — |
| 2 | 4 | 5 | −2+(1) | — |
| 3 | 6 | 7 | −3+(1) | — |
| 4 | — | — | — | 59 |
| 5 | 8 | 9 | −3+(1) | — |
| 6 | 10 | 11 | −4+(1) | — |
| 7 | — | — | — | 4 |
| 8 | — | — | — | 61 |
| 9 | — | — | — | 58 |
| 10 | — | — | — | 62 |
| 11 | 12 | 13 | −1+(1) | — |
| 12 | — | — | — | 57 |
| 13 | — | — | — | 63 |
| . . . | . . . | . . . | . . . | . . . |

# FIG. 8

1110100...                    4,60,59...

| INDEX | INTERNAL VALUE |
|-------|----------------|
| 0 | 60 |
| 1 | −1,(1) |
| 2 | −2,(1) |
| 3 | −3,(1) |
| 4 | 59 |
| 5 | −3,(1) |
| 6 | −4,(1) |
| 7 | 4 |
| 8 | 61 |
| 9 | 58 |
| 10 | 62 |
| 11 | −1+(1) |
| 12 | 57 |
| 13 | 63 |

# FIG. 9

```
        ┌─────────────┐
        │    START    │
        └──────┬──────┘
               │
               ▼
   ┌───────────────────────┐
   │ idx = START INDEX OF  │──── 910
   │    HUFFMAN TABLE      │
   └───────────┬───────────┘
               │
               ▼
        ╱────────────────────╲        ─ 920
       ╱  if(idx==TERMINAL NODE) ╲──── YES ──┐
       ╲                        ╱            │
        ╲──────────────────────╱             │
               │ NO    ─ 940                 │  ─ 930
               ▼                             ▼
   ┌───────────────────────┐     ┌───────────────────────┐
   │ idx = idx − DATA(idx) │     │       RETURN          │
   │   + new − digit 0     │     │   INTERAL VALUE       │
   └───────────────────────┘     └───────────────────────┘
```